# EUROPÄISCHE PATENTSCHRIFT

(11) **EP 2 879 474 B1**
(45) Veröffentlichungstag und Bekanntmachung des Hinweises auf die Patenterteilung: **13.09.2017**
(21) Anmeldenummer: 13195001.6
(22) Anmeldetag: 29.11.2013
(51) Int. Cl.: H05K 7/14, H02M 7/00

(54) **Für 3-Level-Betrieb vorbereitete 2-Level-Umrichtereinheit**
2-level inverter unit prepared for 3-level operation
Unité de convertisseur à 2 niveaux préparée pour un fonctionnement à 3 niveaux

(43) Veröffentlichungstag der Anmeldung: 03.06.2015
(73) Patentinhaber: Siemens Aktiengesellschaft, 80333 München (DE)
(72) Erfinder: Baudelot, Eric, 91085 Weisendorf (DE); Namyslo, Lutz, 91353 Hausen (DE); Sommer, Rainer, 91336 Heroldsbach (DE)

(56) Entgegenhaltungen:
- JP-A- 2009 022 062
- US-A1- 2006 039 127
- US-A1- 2009 219 696
- US-A1- 2010 039 843
- US-A1- 2011 308 834

## Beschreibung

Die vorliegende Erfindung betrifft eine Umrichtereinheit,
- wobei die Umrichtereinheit zwei Versorgungsstromschienen, eine Laststromschiene und eine Mittelpunktstromschiene aufweist,
- wobei von den Versorgungsstromschienen je eine mit einem positiven und einem negativen Versorgungspotenzial verbunden ist,
- wobei die beiden Versorgungsstromschienen deckungsgleich übereinander liegen,
- wobei die Mittelpunktstromschiene und die Versorgungsstromschienen in einem Verbindungsbereich Verbindungsstellen aufweisen, an denen die Mittelpunktstromschiene über Kondensatoreinheiten mit den Versorgungsstromschienen kapazitiv verbunden ist,
- wobei unterhalb der Versorgungsstromschienen in einem Schaltbereich eine 2-Level-Schalteinrichtung angeordnet ist, die einerseits mit den Versorgungsstromschienen und andererseits mit der Laststromschiene verbunden ist,
- wobei die 2-Level-Schalteinrichtung auf einem unterhalb der 2-Level-Schalteinrichtung-angeordneten Hauptkühlkörper angeordnet ist.

Die vorliegende Erfindung betrifft weiterhin eine Gruppe von zwei Umrichtereinheiten, wobei beide Umrichtereinheiten wie obenstehend erläutert ausgebildet sind.

Die Anforderungen an Wechselrichter in Bezug auf die Qualität der erzeugten Spannung steigen mehr und mehr. Mit etablierten Topologien wie beispielsweise dem Zweipunktwechselrichter (2-Level-Umrichter) wird es immer schwerer, mit vernünftigem Aufwand diesen Anforderungen gerecht zu werden.

Eine naheliegende und prinzipiell auch bekannte Lösung ist der Übergang auf einen 3-Level-Umrichter. Ein 3-Level-Umrichter wird jedoch nur dann eingesetzt werden, wenn er erforderlich ist. Wenn ein 2-Level-Umrichter ausreicht, wird dieser verwendet werden. Es ergibt sich daher eine höhere Produktvielfalt.

Aus der US 2009/0 219 696 A1 sind verschiedene Umrichtereinheiten bekannt, die mehrere deckungsgleich übereinander liegende Stromschienen aufweisen. Manche der Umrichtereinheiten sind als 2-Level-Umrichtereinheiten ausgebildet, manche als 3-Level-Umrichtereinheiten. Die Umrichtereinheiten weisen jeweils mehrere deckungsgleich übereinander liegende Stromschienen auf. Bei den 2-Level-Umrichtereinheiten sind die Teileinrichtungen der Schalteinrichtung in voneinander verschiedenen Ebenen angeordnet und mit je einem eigenen Kühlkörper verbunden.

Aus der US 2011/0 308 834 A1 ist eine Umrichtereinheit bekannt, die zwei Versorgungsstromschienen, eine Laststromschiene und eine Mittelpunktstromschiene aufweist. Von den Versorgungsstromschienen ist je eine mit einem positiven und einem negativen Versorgungspotenzial verbunden. Die beiden Versorgungsstromschienen liegen deckungsgleich übereinander. Die Mittelpunktstromschiene und die Versorgungsstromschienen weisen in einem Verbindungsbereich Verbindungsstellen auf, an denen die Mittelpunktstromschiene über Kondensatoreinheiten mit den Versorgungsstromschienen kapazitiv verbunden ist. Unterhalb der Versorgungsstromschienen ist in einem Schaltbereich eine 3-Level-Schalteinrichtung angeordnet, die sowohl mit den Versorgungsstromschienen als auch mit der Mittelpunktstromschiene und der Laststromschiene verbunden ist. Die 3-Level-Schalteinrichtung ist auf einem unterhalb der 3-Level-Schalteinrichtung angeordneten Hauptkühlkörper angeordnet.

Aus der US 2010/0 039 843 A1 ist eine Umrichtereinheit bekannt, wobei eine 3-Level-Schalteinrichtung auf einem Kühlkörper angeordnet ist.

Die Aufgabe der vorliegenden Erfindung besteht darin, einen 2-Level-Umrichter in konstruktiver Hinsicht derart auszugestalten, dass er auf einfache Weise zu einem 3-Level-Umrichter modifiziert werden kann. Es soll also im Regelfall ein Basismodul (= 2-Level-Umrichter) verwendet werden können, wobei das Basismodul jedoch im Bedarfsfall zu einem 3-Level-Umrichter modifiziert werden kann.

Die Aufgabe wird durch eine Umrichtereinheit mit den Merkmalen des Anspruchs 1 gelöst. Vorteilhafte Ausgestaltungen der erfindüngsgemäßen Umrichtereinheit sind Gegenstand der abhängigen Ansprüche 2 bis 6. Anspruch 7 betrifft die Ausgestaltung; in welcher der 3-Level-Umrichter tatsächlich realisiert ist.

Erfindungsgemäß wird eine Umrichtereinheit der eingangs genannten Art dadurch ausgestaltet,
- dass die Umrichtereinheit höhengleich zu der 2-Level-Schalteinrichtung einen Freiraum für eine bidirektionale Schalteinrichtung aufweist, die im Falle ihres Vorhandenseins mit der Laststromschiene und mit der Mittelpunktstromschiene verbunden ist und auf dem Hauptkühlkörper oder einem höhengleich zu dem Hauptkühlkörper angeordneten Zusatzkühlkörper angeordnet ist.

Vorzugsweise ist der Freiraum einerseits vom Verbindungsbereich und andererseits vom Schaltbereich begrenzt. Diese Ausgestaltung ist besonders einfach zu realisieren. Insbesondere ist diese Ausgestaltung unabhängig davon zu realisieren, ob die 2-Level-Schalteinrichtung als einheitliches, mit der Laststromschiene und beiden Versorgungsstromschienen verbundenes Bauteil oder in Form von zwei voneinander getrennten Teilschalteinrichtungen realisiert ist, die beide mit der Laststromschiene und je einer der beiden Versorgungsstromschienen verbunden sind.

In dem Fall, dass die 2-Level-Schalteinrichtung aus zwei voneinander beabstandeten Teilschalteinrichtungen besteht, ist es alternativ möglich, dass der Freiraum zwischen den Teilschalteinrichtungen angeordnet ist.

In den beiden obenstehend erläuterten Ausgestaltungen ist es möglich, dass die Laststromschiene und die Mittelpunktstromschiene auf gleicher Höhe angeordnet sind und unter Einhaltung eines aus Gründen der Spannungsfestigkeit erforderlichen Mindestabstands aneinander angrenzen. Dadurch ergibt sich eine besonders kompakte Gestaltung. Alternativ ist es möglich, dass die Laststromschiene und die Mittelpunktstromschiene in verschiedenen Ebenen angeordnet sind.

Falls die Laststromschiene und die Mittelpunktstromschiene in verschiedenen Ebenen angeordnet sind, ist eine weitere Gestaltung möglich. Insbesondere ist es in diesem Fall möglich,
- dass die Laststromschiene und die Mittelpunktstromschiene sich vom Verbindungsbereich aus gesehen über den Schaltbereich hinaus erstrecken und
- dass der Freiraum in dem von der Laststromschiene und der Mittelpunktstromschiene überdeckten Bereich jenseits des Schaltbereichs angeordnet ist.

Falls der 2-Level-Umrichter zu einem 3-Level-Umrichter umgestaltet werden soll, ist es lediglich erforderlich, dass die bidirektionale Schalteinrichtung in dem Freiraum angeordnet ist. Falls die bidirektionale Schalteinrichtung mittels eines Zusatzkühlkörpers gekühlt wird, muss gegebenenfalls auch der Zusatzkühlkörper hinzugefügt werden. Weitere Modifikationen sind hingegen nicht erforderlich.

Die Aufgabe wird weiterhin durch eine Gruppe von zwei Umrichtereinheiten gelöst, wobei beide Umrichtereinheiten vom Ansatz her gleich ausgebildet sind, wobei jedoch bei einer der beiden Umrichtereinheiten in dem Freiraum die bidirektionale Schalteinrichtung angeordnet ist und bei der anderen der beiden Umrichtereinheiten in dem Freiraum keine bidirektionale Schalteinrichtung angeordnet ist.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die in Verbindung mit den Zeichnungen näher erläutert werden. Hierbei zeigen in schematischer Darstellung:
- FIG 1 ein: Blockschaltbild einer 2-Level-Umrichtereinheit,
- FIG 2: ein Blockschaltbild einer 3-Level-Ümrichtereinheit,
- FIG 3: eine Umrichtereinheit im Schnitt von der Seite,
- FIG 4 und 5: Draufsichten auf zwei Versorgungsstromschienen der Umrichtereinheit von FIG 3,
- FIG 6: eine Draufsicht auf eine Mittelpunktstromschiene und eine Laststromschiene der Umrichtereinheit von FIG 3,
- FIG 7: eine Draufsicht auf Schalteinrichtungen der Umrichtereinheit von FIG 3,
- FIG 8: eine weitere Umrichtereinheit im Schnitt von der Seite,
- FIG 9 und 10: Draufsichten auf zwei Versorgungsstromschienen der Umrichtereinheit von FIG 8,
- FIG 11: eine Draufsicht auf eine Mittelpunktstromschiene und eine Laststromschiene der Umrichtereinheit von FIG 8,
- FIG 12: eine Draufsicht auf Schalteinrichtungen der Umrichtereinheit von FIG 8,
- FIG 13: eine weitere Umrichtereinheit im Schnitt von der Seite,
- FIG 14: eine Draufsicht auf eine Mittelpunktstromschiene der Umrichtereinheit von FIG 13,
- FIG 15: eine Draufsicht auf eine Laststromschiene der Umrichtereinheit von FIG 13,
- FIG 16: eine weitere Umrichtereinheit im Schnitt von der Seite,
- FIG 17: eine Draufsicht auf eine Mittelpunktstromschiene der Umrichtereinheit von FIG 16,
- FIG 18: eine Draufsicht auf eine Laststromschiene der Umrichtereinheit von FIG 16 ist,
- FIG 19: eine weitere Umrichtereinheit im Schnitt von der Seite,
- FIG 20 und 21: Draufsichten auf zwei Versorgungsstromschienen der Umrichtereinheit von FIG 19 und
- FIG 22: eine Draufsicht auf eine Mittelpunktstromschiene der Umrichtereinheit von FIG 19,
- FIG 23: eine Draufsicht auf eine Laststromschiene der Umrichtereinheit von FIG 19 und
- FIG 24: eine Draufsicht auf Schalteinrichtungen der Umrichtereinheit von FIG 19.

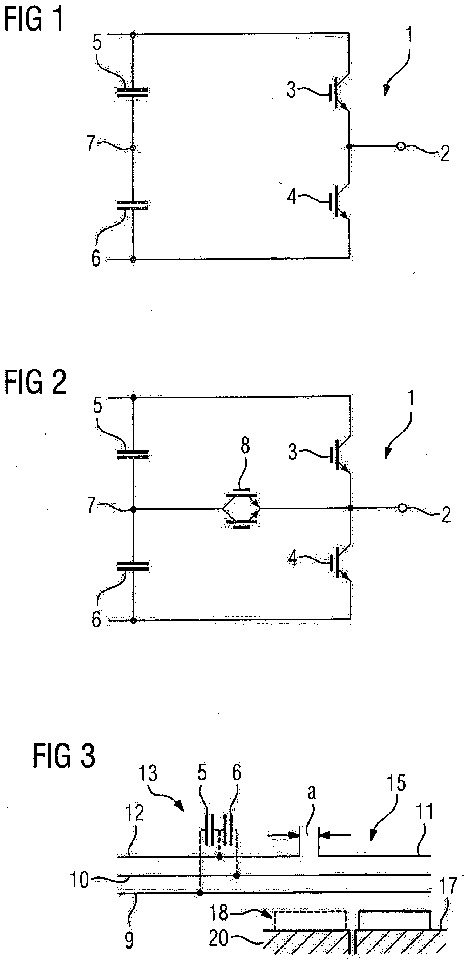

Gemäß FIG 1 ist eine Umrichtereinheit im einfachsten Fall als 2-Level-Umrichtereinheit ausgebildet. Die Umrichtereinheit weist in diesem Fall eine 2-Level-Schalteinrichtung 1 auf, mittels derer ein Lastanschluss 2 alternativ mit einem positiven oder einem negativen Versorgungspotenzial verbunden werden kann. Die 2-Level-Schalteinrichtung 1 kann zu diesem Zweck als einheitliche Schalteinrichtung ausgebildet sein. In diesem Fall ist die 2-Level-Schalteinrichtung 1 als ein einziges Bauteil ausgebildet, das sowohl mit dem Lastanschluss 2 als auch mit beiden Versorgungspotenzialen verbunden ist. Alternativ kann sie entsprechend der Darstellung in FIG 1 zwei Teilschalteinrichtungen 3, 4 aufweisen. In diesem Fall ist die eine Teilschalteinrichtung 3 mit dem Lastanschluss 2 und dem einen Versorgungspotenzial verbunden, die andere Teilschalteinrichtung 4 mit dem Lastanschluss 2 und dem anderen Versorgungspotenzial. Üblicherweise vorhandene Freilaufdioden sind in FIG 1 nicht mit eingezeichnet, weil sie im Rahmen der vorliegenden Erfindung nicht relevant sind. Die beiden Versorgungspotenziale sind in der Regel über Kondensatoreinheiten 5, 6 mit einem Mittelpunkt 7 verbunden, der ein mittleres Potential (Nullpotenzial) aufweist. Die Kondensatoreinheiten 5, 6 können nach Bedarf Reihen- und Parallelschaltungen von Kondensatoren umfassen.

Falls die Umrichtereinheit als 3-Level-Umrichtereinheit ausgebildet sein soll, ist gemäß FIG 2 zusätzlich zu den obenstehend in Verbindung mit FIG 1 erläuterten Elementen eine bidirektionale Schalteinrichtung 8 vorhanden, die einerseits mit dem Mittelpunkt 7 und andererseits mit dem Lastanschluss 2 verbunden ist. Auch in FIG 2 sind etwaige Freilaufdioden nicht mit eingezeichnet.

Zur Realisierung einer 2-Level-Umrichtereinheit, die auf einfache Weise zu einer 3-Level-Umrichtereinheit modifiziert werden kann, weist eine erfindungsgemäße Umrichtereinheit in einer ersten Ausführungsform der vorliegenden Erfindung gemäß FIG 3 zwei Versorgungsstromschienen 9, 10, eine Laststromschiene 11 und eine Mittelpunktstromschiene 12 auf. Die Stromschienen 9 bis 12 sind gemäß FIG 3 in drei Ebenen übereinander angeordnet. Die Reihenfolge der Stromschienen 9 bis 12 ist sowohl im Rahmen der Ausgestaltung von FIG 3 als auch im Rahmen der anderen Ausgestaltungen von untergeordneter Bedeutung. Zur Isolierung der Stromschienen 9 bis 12 voneinander erforderliche Isolierschichten sind in FIG 3 (und auch den anderen FIG) aus Gründen der Übersichtlichkeit nicht mit dargestellt.

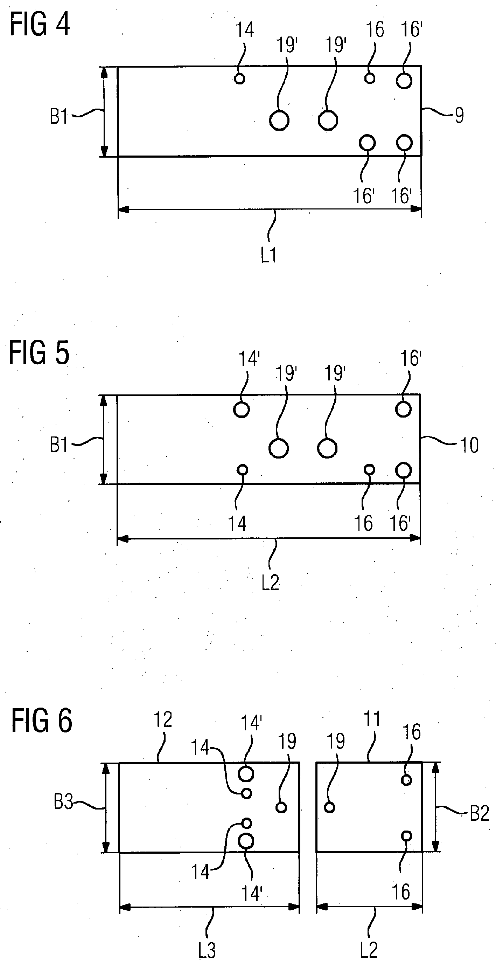

Von den beiden Versorgungsstromschienen 9, 10 ist je eine mit dem positiven und dem negativen Versorgungspotenzial verbunden. Sie liegen deckungsgleich übereinander. Sie weisen also - siehe insbesondere die FIG 4 und 5 - gleiche Längen L1 und gleiche Breiten B1 auf.

Die Laststromschiene 11 und die Mittelpunktstromschiene 12 sind gemäß FIG 3 auf gleicher Höhe angeordnet. Ihre Breite B2, B3 kann gemäß FIG 6 zwar mit der Breite B1 der Versorgungsstromschienen 9, 10 übereinstimmen. Ihre Längen L2, L3 sind jedoch zwangsweise geringer. Insbesondere ist die Summe der Längen L2 und L3 in der Regel (geringfügig) kleiner als die Länge L1 der Versorgungsstromschienen 9, 10. Die (geringfügige) Differenz ergibt sich daraus, dass aus Gründen der Spannungsfestigkeit ein Mindestabstand a von wenigen Millimetern zwischen der Laststromschiene 11 und der Mittelpunktstromschiene 12 eingehalten werden muss. Sofern der Mindestabstand a vernachlässigt wird, grenzen die Laststromschiene 11 und die Mittelpunktstromschiene 12 aneinander an.

Die Mittelpunktstromschiene 12 und die Versorgungsstromschienen 9, 10 weisen in einem Verbindungsbereich 13 Verbindungsstellen 14 auf. An den Verbindungsstellen 14 sind die Kondensatoreinheiten 5, 6 mit der Mittelpunktstromschiene 12 und den Versorgungsstromschienen 9, 10 verbunden. Über die Kondensatoreinheiten 5, 6 erfolgt also eine kapazitive Verbindung der Mittelpunktstromschiene 12 mit den Versorgungsstromschienen 9, 10. Die Ausgestaltung der entsprechenden Verbindungselemente als solche - in FIG 3 durch gestrichelte Linien angedeutet - ist Fachleuten bekannt. Weiterhin ist Fachleuten ebenfalls bekannt und auch ohne weiteres ersichtlich, dass die Stromschienen 9 bis 12, sofern sie von derartigen Verbindungselementen durchdrungen werden, entsprechende Ausnehmungen aufweisen müssen. Die Ausnehmungen müssen (selbstverständlich) einen geringfügig größeren Querschnitt aufweisen als die Verbindungselemente. Die Ausnehmungen sind in den FIG 5 und 6 mit dem Bezugszeichen 14' versehen. Es ist möglich, dass die Verbindungsstellen 14 entsprechend der Darstellung von FIG 3 gestaffelt angeordnet sind. In der Regel sind die Verbindungsstellen 14 jedoch entsprechend der Darstellung in den FIG 4 und 6 auf gleicher Höhe angeordnet.

Unterhalb der Versorgungsstromschienen 9, 10 ist in einem Schaltbereich 15 die 2-Level-Schalteinrichtung 1 angeordnet. Die 2-Level-Schalteinrichtung 1 ist über Anschlussstellen 16 einerseits mit den Versorgungsstromschienen 9, 10 und andererseits mit der Laststromschiene 11 verbunden. Die Ausgestaltung der entsprechenden Verbindungselemente - in FIG 3 ebenfalls durch gestrichelte Linien angedeutet - ist Fachleuten wiederum bekannt. Die zugehörigen Ausnehmungen für von diesen Verbindungselementen durchdrungene Stromschienen 9 bis 12 sind in den FIG 4 und 5 mit dem Bezugszeichen 16' versehen.

Die 2-Level-Schalteinrichtung 1 ist auf einem Hauptkühlkörper 17 angeordnet, der ebenfalls Bestandteil der Umrichtereinheit ist. Der Hauptkühlkörper 17 ist unterhalb der 2-Level-Schalteinrichtung 1 angeordnet.

Die 2-Level-Schalteinrichtung 1 ist gemäß FIG 3 unmittelbar unterhalb der Versorgungsstromschienen 9, 10 angeordnet, weil die Laststromschiene 11 und die Mittelpunktstromschiene 12 oberhalb der Versorgungsstromschienen 9, 10 angeordnet sind. Dies ist jedoch, wie bereits erwähnt, von untergeordneter Bedeutung.

Um die Umrichtereinheit auf einfache Weise von einer 2-Level-Umrichtereinheit in eine 3-Level-Umrichtereinheit umrüsten zu können, weist die Umrichtereinheit einen Freiraum 18 auf . Der Freiraum 18 ist für die bidirektionale Schalteinrichtung 8 bestimmt. In dem Freiraum 18 kann also bei Bedarf die bidirektionale Schalteinrichtung 8 angeordnet werden. Der Freiraum 18 ist höhengleich zu der 2-Level-Schalteinrichtung 1 angeordnet. Der Freiraum 18 ist bei der ersten Ausführungsform einerseits vom Verbindungsbereich 13 und andererseits vom Schaltbereich 15 begrenzt. Seine Dimensionierung entspricht im Wesentlichen der Größe des Schaltbereichs 15. Insbesondere liegt sie in der Regel zwischen 80 % und 120 % der Größe des Schaltbereichs 15.

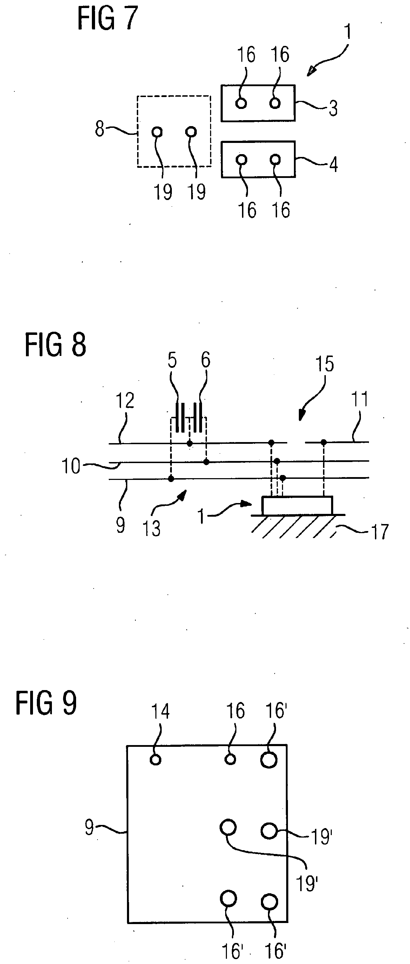

Die bidirektionale Schalteinrichtung 8 kann vorhanden sein, muss aber nicht vorhanden sein. Die bidirektionale Schalteinrichtung 8 ist daher in FIG 3 und auch in FIG 7 nur gestrichelt eingezeichnet. Falls die bidirektionale Schalteinrichtung 8 vorhanden ist, ist sie über zusätzliche Anschlüsse 19 mit der Laststromschiene 11 und der Mittelpunktstromschiene 12 verbunden. Die Ausgestaltung der entsprechenden Verbindungselemente - in FIG 3 wiederum durch gestrichelte Linien angedeutet - ist Fachleuten bekannt. Die zugehörigen Ausnehmungen für von diesen Verbindungselementen durchdrungene Stromschienen 9 bis 12 sind in den FIG 4 und 5 mit dem Bezugszeichen 19' versehen.

Weiterhin ist die bidirektionale Schalteinrichtung 8 auf einem Kühlkörper 17, 20 angeordnet. Bei dem Kühlkörper 17, 20, auf dem die bidirektionale Schalteinrichtung 8 angeordnet ist, kann es sich um den Hauptkühlkörper 17 handeln. Alternativ kann es sich bei dem Kühlkörper 17, 20 um einen vom Hauptkühlkörper 17 verschiedenen Zusatzkühlkörper 20 handeln. Der Zusatzkühlkörper 20 ist, sofern er vorhanden ist, gemäß der Darstellung in FIG 3 höhengleich zu dem Hauptkühlkörper 17 angeordnet.

Die Ausgestaltung gemäß dem in den FIG 8 bis 12 dargesellten zweiten Ausführungsbeispiel korrespondiert über weite Strecken mit dem ersten Ausführungsbeispiel der FIG 3 bis 7. Gleiche Elemente sind daher mit gleichen Bezugszeichen versehen. Weiterhin wird nachstehend nur auf die Unterschiede näher eingegangen.

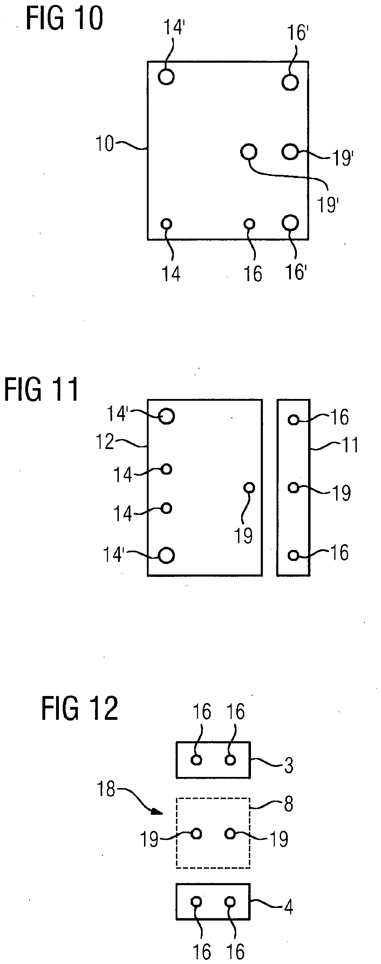

Bei dem zweiten Ausführungsbeispiel der FIG 8 bis 12 besteht die 2-Level-Schalteinrichtung 1 aus den zwei voneinander beabstandeten Teilschalteinrichtungen 3, 4. Die eine Teilschalteinrichtung 3 ist mit dem Lastanschluss 2 und dem einen Versorgungspotenzial verbunden, die andere Teilschalteinrichtung 4 mit dem Lastanschluss 2 und dem anderen Versorgungspotenzial. Die Teilschalteinrichtungen 3, 4 sind gemäß den FIG 8 und 12 in Breitenrichtung voneinander beabstandet. Ihr Abstand voneinander ist so groß, dass der Freiraum 18 zwischen den Teilschalteinrichtungen 3, 4 angeordnet sein kann. Im Übrigen entspricht die Ausgestaltung der FIG 8 bis 12 der Ausgestaltung der FIG 3 bis 7.

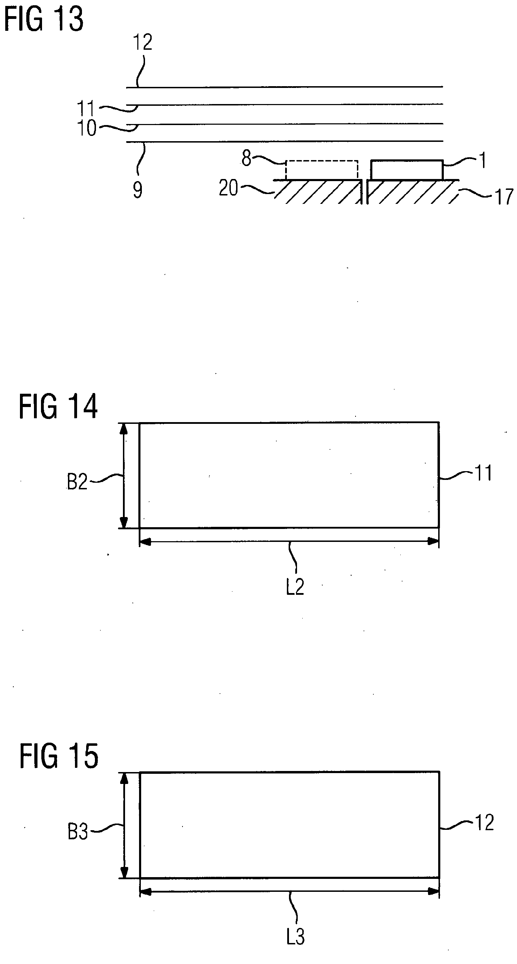

Die Ausgestaltung gemäß dem in den FIG 13 bis 15 dargestellten dritten Ausführungsbeispiel korrespondiert über weite Strecken ebenfalls mit dem ersten Ausführungsbeispiel der FIG 3 bis 7. Auch hier sind daher gleiche Elemente mit gleichen Bezugszeichen versehen und wird nur auf die Unterschiede näher eingegangen.

Bei dem dritten Ausführungsbeispiel der FIG 13 bis 15 sind die Laststromschiene 11 und die Mittelpunktstromschiene 12 nicht auf gleicher Höhe angeordnet, sondern in voneinander verschiedenen Ebenen. Jede der Stromschienen 9 bis 12 ist also in einer eigenen Ebene angeordnet. Die Laststromschiene 11 und die Mittelpunktstromschiene 12 können daher gemäß den FIG 14 und 15 die gleichen Abmessungen aufweisen wie die Versorgungsstromschienen 9, 10. Dies ist jedoch nicht zwingend erforderlich. Im Übrigen entspricht die Ausgestaltung der FIG 13 bis 15 der Ausgestaltung der FIG 3 bis 7.

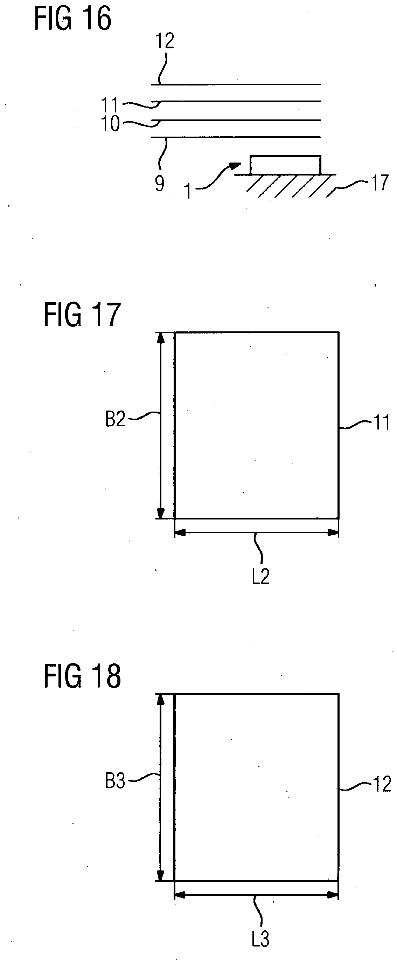

Die Ausgestaltung gemäß dem in den FIG 16 bis 18 dargestellten vierten Ausführungsbeispiel korrespondiert über weite Strecken mit dem zweiten Ausführungsbeispiel der FIG 8 bis 12. Auch hier sind daher gleiche Elemente mit gleichen Bezugszeichen versehen und wird nur auf die Unterschiede näher eingegangen.

Bei dem vierten Ausführungsbeispiel der FIG 16 bis 18 sind die Laststromschiene 11 und die Mittelpunktstromschiene 12 nicht auf gleicher Höhe angeordnet, sondern in voneinander verschiedenen Ebenen. Analog zum dritten Ausführungsbeispiel ist also beim vierten Ausführungsbeispiel jede der Stromschienen 9 bis 12 in einer eigenen Ebene angeordnet. Im Übrigen entspricht die Ausgestaltung der FIG 16 bis 18 der Ausgestaltung der FIG 8 bis 12.

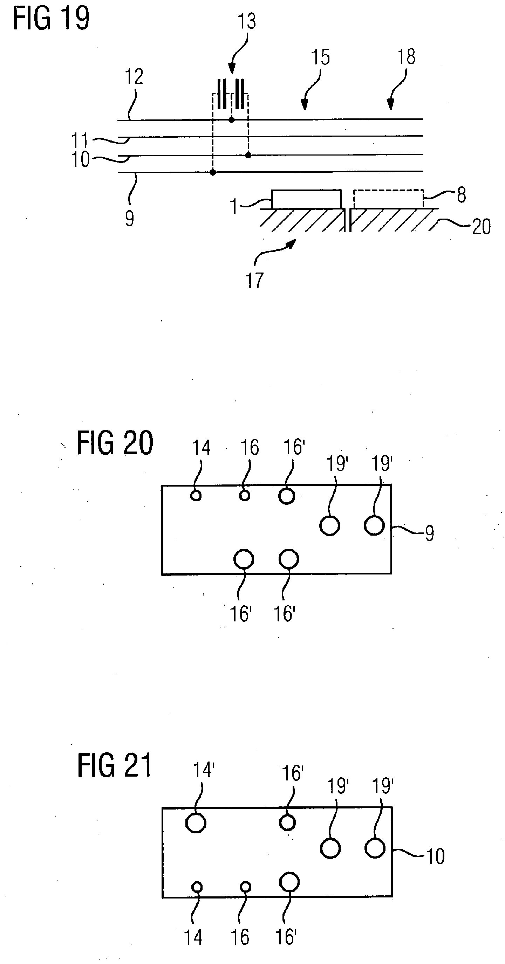

Die Ausgestaltung gemäß dem in den FIG 19 bis 24 dargestellten fünften Ausführungsbeispiel geht ebenfalls von dem ersten Ausführungsbeispiel der FIG 3 bis 7 aus. Es weist jedoch weitergehende Modifikationen als das zweite, dritte und vierte Ausführungsbeispiel auf. Auch bei dem fünften Ausführungsbeispiel sind gleiche Elemente mit gleichen Bezugszeichen versehen und wird nur auf die Unterschiede näher eingegangen.

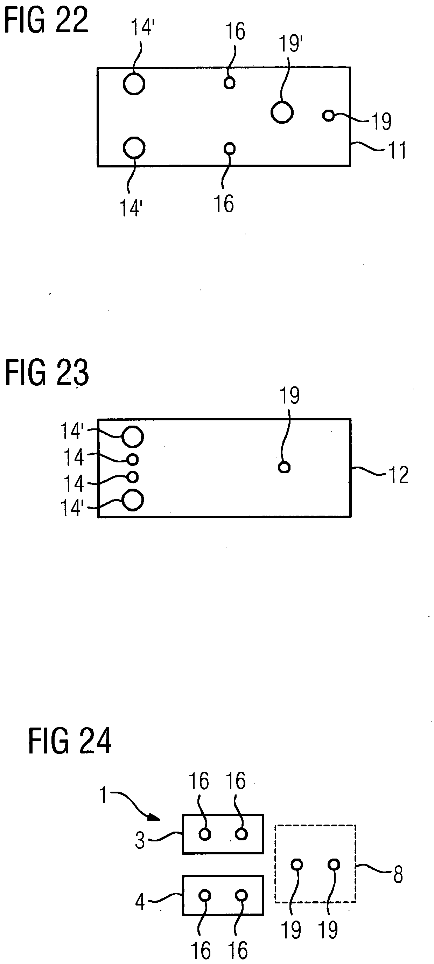

Bei dem fünften Ausführungsbeispiel sind die Laststromschiene 11 und die Mittelpunktstromschiene 12 - analog zum dritten und vierten Ausführungsbeispiel - in verschiedenen Ebenen angeordnet. Im Gegensatz zu den anderen Ausführungsbeispielen, bei denen die Stromschienen 9 bis 12 im Schaltbereich 15 enden, erstrecken sich die Laststromschiene 11 und die Mittelpunktstromschiene 12 in diesem Ausführungsbeispiel jedoch vom Verbindungsbereich 13 aus gesehen gemäß den FIG 19, 22 und 23 über den Schaltbereich 15 hinaus. Es ist möglich, dass auch die Versorgungsstromschienen 9, 10 sich über den Schaltbereich 15 hinaus erstrecken. Dies ist jedoch nicht zwingend erforderlich. Bei der fünften Ausgestaltung ist der Freiraum 18 gemäß den FIG 19 und 24 in dem von der Laststromschiene 11 und der Mittelpunktstromschiene 12 überdeckten Bereich jenseits des Schaltbereichs 15 angeordnet.

Bei der Ausgestaltung gemäß dem fünften Ausführungsbeispiel ist die bidirektionale Schalteinrichtung 8, sofern sie vorhanden ist, entsprechend der Darstellung in FIG 19 vorzugsweise auf dem Zusatzkühlkörper 20 angeordnet. Dies ist jedoch nicht zwingend erforderlich.

Erfindungsgemäß besteht der Unterschied zwischen zwei Umrichtereinheiten, von denen die eine als 2-Level-Umrichtereinheit und die andere als 3-Level-Umrichtereinheit ausgebildet ist, somit darin, dass bei der 3-Level-Umrichtereinheit in dem Freiraum 18 dieser Umrichtereinheit die bidirektionale Schalteinrichtung 8 angeordnet ist und bei der 2-Level-Umrichtereinheit in dem Freiraum 18 dieser Umrichtereinheit keine bidirektionale Schalteinrichtung angeordnet ist. Weiterhin kann bei der 3-Level-Umrichtereinheit eventuell der Zusatzkühlkörper 20 vorhanden sein. Im Übrigen sind beide Umrichtereinheiten gleich ausgebildet. Es ist daher auf einfache Weise eine Umrüstung einer 2-Level-Umrichtereinheit in eine 3-Level-Umrichtereinheit und umgekehrt möglich.

Zusammengefasst betrifft die vorliegende Erfindung somit folgenden Sachverhalt:
Eine Umrichtereinheit weist zwei Versorgungsstromschienen 9, 10, eine Laststromschiene 11 und eine Mittelpunktstromschiene 12 auf. Von den Versorgungsstromschienen 9, 10 ist je eine mit einem positiven und einem negativen Versorgungspotenzial verbunden. Die beiden Versorgungsstromschienen 9, 10 liegen deckungsgleich übereinander. Die Mittelpunktstromschiene 12 und die Versorgungsstromschienen 9, 10 weisen in einem Verbindungsbereich 13 Verbindungsstellen 14 auf, an denen die Mittelpunktstromschiene 12 über Kondensatoreinheiten 5, 6 mit den Versorgungsstromschienen 9, 10 kapazitiv verbunden ist. Unterhalb der Versorgungsstromschienen 9, 10 ist in einem Schaltbereich 15 eine 2-Level-Schalteinrichtung 1 angeordnet, die ihrerseits auf einem unterhalb der 2-Level-Schalteinrichtung 1 angeordneten Hauptkühlkörper 17 angeordnet ist. Die Umrichtereinheit weist höhengleich zu der 2-Level-Schalteinrichtung 1 einen Freiraum 18 für eine bidirektionale Schalteinrichtung 8 auf. Im Falle ihres Vorhandenseins ist die bidirektionale Schalteinrichtung 18 mit der Laststromschiene 11 und mit der Mittelpunktstromschiene 12 verbunden und auf dem Hauptkühlkörper 17 oder einem höhengleich zu dem Hauptkühlkörper 17 angeordneten Zusatzkühlkörper 20 angeordnet.

Die vorliegende Erfindung weist viele Vorteile auf. Insbesondere ist es auf einfache Weise möglich, die bidirektionale Schalteinrichtung 8 ohne weitergehende Modifikationen der Umrichtereinheit einzubauen oder auszubauen. Der Grundaufbau (2-Level-Umrichtereinheit) ist daher ohne weiteres modular zu einer 3-Level-Umrichtereinheit erweiterbar. Weiterhin ist auf einfache und zuverlässige Weise eine niederinduktive Verbindung der Schalteinrichtungen 1, 8 mit den verschiedenen Stromschienen 9 bis 12 möglich.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Umrichtereinheit,
- wobei die Umrichtereinheit zwei Versorgungsstromschienen (9,10), eine Laststromschiene (11) und eine Mittelpunktstromschiene (12) aufweist,
- wobei von den Versorgungsstromschienen (9,10) je eine mit einem positiven und einem negativen Versorgungspotenzial verbunden ist,
- wobei die beiden Versorgungsstromschienen (9,10) deckungsgleich übereinander liegen,
- wobei die Mittelpunktstromschiene (12) und die Versorgungsstromschienen (9,10) in einem Verbindungsbereich (13) Verbindungsstellen (14) aufweisen, an denen die Mittelpunktstromschiene (12) über Kondensatoreinheiten (5,6) mit den Versorgungsstromschienen (9,10) kapazitiv verbunden ist,
- wobei unterhalb der Versorgungsstromschienen (9,10) in einem Schaltbereich (15) eine 2-Level-Schalteinrichtung (1) angeordnet ist, die einerseits mit den Versorgungsstromschienen (9,10) und andererseits mit der Laststromschiene (11) verbunden ist,
- wobei die 2-Level-Schalteinrichtung (1) auf einem unterhalb der 2-Level-Schalteinrichtung (1) angeordneten Hauptkühlkörper (17) angeordnet ist,
- wobei die Umrichtereinheit höhengleich zu der 2-Level-Schalteinrichtung (1) einen Freiraum (18) für eine bidirektionale Schalteinrichtung (8) aufweist, die im Falle ihres Vorhandenseins mit der Laststromschiene (11) und mit der Mittelpunktstromschiene (12) verbunden ist und auf dem Hauptkühlkörper (17) oder einem höhengleich zu dem Hauptkühlkörper (17) angeordneten Zusatzkühlkörper (20) angeordnet ist.

2. Umrichtereinheit nach Anspruch 1, **dadurch ge- kennzeichnet,** dass der Freiraum (18) einerseits vom Verbindungsbereich (13) und andererseits vom Schaltbereich (15) begrenzt ist.

3. Umrichtereinheit nach Anspruch 1, **dadurch gekennzeichnet, dass** die 2-Level-Schalteinrichtung (1) aus zwei voneinander beabstandeten Teilschalteinrichtungen (3, 4) besteht und dass der Freiraum (18) zwischen den Teilschalteinrichtungen (3, 4) angeordnet ist.

4. Umrichtereinheit nach Anspruch 2 oder 3, **dadurch g ekennzeichnet**, dass die Laststromschiene (11) und die Mittelpunktstromschiene (12) auf gleicher Höhe angeordnet sind und unter Einhaltung eines aus Gründen der Spannungsfestigkeit erforderlichen Mindestabstandes (a) aneinander angrenzen.

5. Umrichtereinheit nach Anspruch 1, 2 oder 3, **dadurch g ekennzeichnet,** dass die Laststromschiene (11) und die Mittelpunktstromschiene (12) in verschiedenen Ebenen angeordnet sind.

6. Umrichtereinheit nach Anspruch 1, **dadurch gekennzeichnet, dass**
- dass die Laststromschiene (11) und die Mittelpunktstromschiene (12) in verschiedenen Ebenen angeordnet sind,
- dass die Laststromschiene (11) und die Mittelpunktstromschiene (12) sich vom Verbindungsbereich (13) aus gesehen über den Schaltbereich (15) hinaus erstrecken und
- dass der Freiraum (18) in dem von der Laststromschiene (11) und der Mittelpunktstromschiene (12) überdeckten Bereich jenseits des Schaltbereichs (15) angeordnet ist.

7. Umrichtereinheit nach einem der obigen Ansprüche, d a - durch **gekennzeichnet,** dass die bidirektionale Schalteinrichtung (8) in dem Freiraum (18) angeordnet ist.

8. Gruppe von zwei Umrichtereinheiten, wobei beide Umrichtereinheiten nach demselben der Ansprüche 1 bis 6 ausgebildet sind, wobei bei einer der beiden Umrichtereinheiten in dem Freiraum (18) die bidirektionale Schalteinrichtung (8) angeordnet ist und bei der anderen der beiden Umrichtereinheiten in dem Freiraum (18) keine bidirektionale Schalteinrichtung angeordnet ist.

## Claims

1. Inverter unit,
- wherein the inverter unit has two supply busbars (9, 10), a load busbar (11) and a central busbar (12),
- wherein each supply busbar (9, 10) is connected to a positive and a negative supply potential,
- wherein the two supply busbars (9, 10) are disposed congruently one on top of the other,
- wherein in a connection area (13) the central busbar (12) and the supply busbars (9, 10) have connecting points (14), at which the central busbar (12) is capacitively connected to the supply busbars (9, 10) by way of capacitor units (5, 6),
- wherein a 2-level switching device (1), which is connected to the supply busbars (9, 10) on the one hand and to the load busbar (11) on the other hand, is arranged in a switching range (15) below the supply busbars (9, 10),
- wherein the 2-level switching device (1) is arranged on a main cooling element (17) arranged below the 2-level switching device (1),
- wherein at the same height as the 2-level switching device (1) the inverter unit has a gap (18) for a bidirectional switching device (8), which, in the event of its presence, is connected to the load busbar (11) and to the central busbar (12) and is arranged on the main cooling element (17) or an additional cooling element (20) arranged at the same height as the main cooling element (17).

2. Inverter unit according to claim 1, **characterised in that** the gap (18) is delimited by the connection area (13) on the one hand and by the switching range (15) on the other hand.

3. Inverter unit according to claim 1, **characterised in that** the 2-level switching device (1) consists of two partial switching devices (3, 4) which are distanced from one another and that the gap (18) is arranged between the partial switching devices (3, 4).

4. Inverter unit according to claim 2 or 3, **characterised in that** the load busbar (11) and the central busbar (12) are arranged at the same height and abut one another while observing a minimum distance (a) required for reasons of electrical strength.

5. Inverter unit according to claim 1, 2 or 3, **characterised in that** the busbar (11) and the central busbar (12) are arranged on different levels.

6. Inverter unit according to claim 1, **characterised in that**
- the load busbar (11) and the central busbar (12) are arranged on different levels,
- the load busbar (11) and the central busbar (12) extend beyond the switching range (15) when viewed from the connection area (13) and
- the gap (18) is arranged on the other side of the switching range (15) in the area covered by the load busbar (11) and the central busbar (12).

7. Inverter unit according to one of the above claims, **characterised in that** the bidirectional switching device (8) is arranged in the gap (18).

8. Group of two inverter units, wherein both inverter units are embodied according to the same one of claims 1 to 6, wherein with one of the two inverter units the bidirectional switching device (8) is arranged in the gap (18) and with the other of the two inverter units there is no bidirectional switching device arranged in the gap (18).

## Revendications

1. Unité de convertisseur,
- dans laquelle l'unité de convertisseur a deux rails (9, 10) de courant d'alimentation, un rail (11) de courant de charge et un rail (12) de courant central,
- dans lequel aux rails (9, 10) de courant d'alimentation est relié respectivement un potentiel d'alimentation positif et un potentiel d'alimentation négatif,
dans laquelle les deux rails (9, 10) de courant d'alimentation sont l'un sur l'autre en coïncidence,
- dans laquelle le rail (12) de courant central et les rails (9, 10) de courant d'alimentation ont, en une région (13) de liaison, des points (14) de liaison où le rail (12) de courant central est relié capacitivement aux rails (9, 10) de courant d'alimentation par des unités (5, 6) de condensateur,
- dans laquelle, en dessous des rails (9, 10) de courant d'alimentation, est disposé, dans une région (15) de commutation, un dispositif (1) de commutation à deux niveaux, qui est relié d'une part aux rails (9, 10) d'alimentation en courant, et d'autre part au rail (11) de courant de charge,
- dans laquelle le dispositif (1) de commutation à deux niveaux est disposé sur un refroidisseur (17) principal disposé en dessous du dispositif (1) de commutation à deux niveaux,
- dans laquelle l'unité de convertisseur a, au même niveau que le dispositif (1) de commutation à deux niveaux, un espace (18) libre pour un dispositif (8) de commutation bidirectionnel, qui, dans le cas de sa présence, est relié au rail (11) de courant de charge et au rail (12) de courant central et qui est disposé sur le refroidisseur (17) principal ou sur un refroidisseur (20) supplémentaire disposé au même niveau que le refroidisseur (17) principal.

2. Unité de convertisseur suivant la revendication 1, **caractérisée en ce que** l'espace (18) libre est délimité d'une part par la région (13) de liaison et d'autre part par la région (15) de commutation.

3. Unité de convertisseur suivant la revendication 1, **caractérisée en ce que** le dispositif (1) de commutation à deux niveaux est constitué de deux sous dispositifs (3, 4) de commutation, à distance l'un de l'autre, et **en ce que** l'espace (18) libre est disposé entre les sous dispositifs (3, 4) de commutation.

4. Unité de convertisseur suivant la revendication 2 ou 3, **caractérisée en ce que** le rail (11) de courant de charge et le rail (12) de courant central sont disposés à un même niveau et, en maintenant une distance (a) minimum nécessaire pour des raisons de rigidité diélectrique, sont voisins l'un de l'autre.

5. Unité de convertisseur suivant la revendication 1, 2 ou 3, **caractérisée en ce que** le rail (11) de courant de charge et le rail (12) de courant central sont disposés dans des plans différents.

6. Unité de convertisseur suivant la revendication 1, **caractérisée en ce que**
- le rail (11) de courant de charge et le rail (12) de courant central sont disposés dans des plans différents,
- **en ce que** le rail (11) de courant de charge et le rail (12) de courant central s'étendent, considéré depuis la région (13) de liaison, au-delà de la région (15) de commutation et
- **en ce que** l'espace (18) libre est disposé au-delà de la région (15) de commutation, dans la région recouverte par le rail (11) de courant de charge et par le rail (12) de courant central.

7. Unité de convertisseur suivant l'une des revendications précédentes, **caractérisée en ce que** le dispositif (8) de commutation bidirectionnel est disposé dans l'espace (18) libre.

8. Groupe de deux unités de convertisseur, les deux convertisseurs étant constitués suivant la même des revendications 1 à 6, dans lequel, pour l'une des deux unités de convertisseur, le dispositif (8) de commutation bidirectionnel est disposé dans l'espace (18) libre et, pour l'autre des deux unités de convertisseur, un dispositif de commutation bidirectionnel n'est pas disposé dans l'espace (18) libre.
